# EUROPEAN PATENT SPECIFICATION

(11) **EP 2 927 950 B1**
(45) Date of publication and mention of the grant of the patent: **16.02.2022**
(21) Application number: 13858236.6
(22) Date of filing: 27.05.2013
(51) Int. Cl.: H05K 3/40, H05K 1/11, H01L 23/498, H05K 3/34, H05K 3/46

(54) **WIRING BOARD**
LEITERPLATINE
CARTE DE CÂBLAGE

(30) Priority: 27.11.2012 JP 2012258279
(43) Date of publication of application: 07.10.2015
(73) Proprietor: NGK Spark Plug Co., Ltd., Aichi 4678525 (JP)
(72) Inventor: WADA, Hidetoshi, Nagoya-shi Aichi 467-8525 (JP); ITO, Tatsuya, Nagoya-shi Aichi 467-8525 (JP); NAGAI, Makoto, Nagoya-shi Aichi 467-8525 (JP)
(74) Representative: Cabinet Beau de Loménie
(86) International application number: PCT/JP2013/003341
(87) International publication number: WO 2014/083718

(56) References cited:
- JP-A- H1 098 131
- JP-A- H09 306 952
- JP-A- H09 321 090
- JP-A- 2002 271 101
- JP-A- 2008 021 883
- JP-A- 2012 064 911
- US-A- 5 523 920
- US-A1- 2006 225 917
- US-A1- 2008 257 595
- US-A1- 2010 193 947
- US-A1- 2011 108 315

## Description

### TECHNICAL FIELD

The present invention relates to a wiring substrate (board) in which connection terminals for connection with a semiconductor chip are formed on a main face of the wiring substrate.

### BACKGROUND ART

In general, a main face (surface) of a wiring substrate on which a semiconductor chip is to be mounted has connection terminals for connection with the semiconductor chip. The connection terminals are connected to wirings of a lower layer. In order to guarantee the reliability of the connection, the connection terminals are formed on circular or rectangular metal layers called "lands" whose sizes (areas) are greater than those of openings of a solder resist layer (see, for example, Patent Document 1).

### PRIOR ART DOCUMENT

### PATENT DOCUMENT

Patent Document 1: Japanese Patent Application Laid-Open (kokai) No. 2012-54297

US 2006/225917 discloses a conductive bump structure and a fabrication method thereof.

US 2011/108315 discloses a process for fabricating a circuit substrate and a circuit substrate.

US 2008/257595 discloses a packaging substrate and a method for fabricating the same.

US 2010/193947 discloses a flip chip interconnection having narrow interconnection sites on the substrate.

US 5523920 discloses printed circuit board comprising elevated bound pads.

### SUMMARY OF THE INVENTION

### PROBLEM TO BE SOLVED BY THE INVENTION

In recent years, since the density of connection terminals has been increased, the intervals (pitch) of disposed connection terminals are required to be narrower. However, in the invention disclosed in Patent Document 1, lands whose areas are greater than those of the connection terminals are provided as a substrate wiring, and connection terminals are formed on the lands. Therefore, increasing the density of the connection terminals is difficult. Also, since wirings must be routed while avoiding the lands, the layout of the wirings is restricted. Therefore, it is necessary to provide an additional wiring layer in order to form wirings which cannot be routed. Also, the increasing density of connection terminals requires a reduction in the size of the connection terminals. Therefore, it has been impossible to secure a sufficiently large area of contact between each connection terminal and a corresponding land, and the connection terminals may separate from the lands.

The present invention has been accomplished in order to cope with the above-described circumstances, and an object of the invention is to provide a wiring substrate which allows connection terminals to be disposed at high density, can increase the degree of freedom of wiring layout, and can enhance the reliability of connection of the connection terminals.

### MEANS FOR SOLVING THE PROBLEM

In order to achieve the above-described object, the present prevent invention provides a wiring substrate as defined in claim 1. The wiring substrate comprises a laminate which includes one or more insulating layers and one or more conductor layers laminated together; a wiring formed on the laminate; a columnar connection terminal which is formed directly on the wiring and is in contact with at least one of opposite side surfaces of the wiring; and a solder resist layer which covers the wiring and which exposes at least a portion of the connection terminal, wherein a width of the wiring at a position at which the connection terminal is formed is smaller than a length of the connection terminal in the width direction.

According to the present invention, the connection terminal is formed directly on the wiring . Therefore, it is unnecessary to provide a land for the connection terminal. Also, the width of the wiring at a position where the connection terminal is formed is smaller than the length of the connection terminal in the width direction. Therefore, connection terminals can be disposed at high density. Also, the degree of freedom of wiring layout can be increased.

Further, the connection terminal is in contact with at least one of the opposite side surfaces of the wiring. Therefore, the reliability of connection between the connection terminal and the wiring increases.

Notably, in one mode of the present invention, the wiring substrate is characterized in that the connection terminal and the wiring are formed of the same material.

According to the present invention, the material of the connection terminal and the material of the wiring are the same. Therefore, the reliability of connection between the connection terminal and the wiring increases further.

Also, in the present invention, the wiring substrate is characterized in that a lower surface of the connection terminal which faces an upper surface of the wiring has a contact surface which is in contact with the upper surface of the wiring and a separation surface which is not in contact with the upper surface of the wiring, and the gap between the separation surface and the upper surface of the wiring is filled with the solder resist layer.

According to the present invention, the gap between the separation surface of the connection terminal and the upper surface of the wiring is filled with the solder resist layer. Therefore, the adhesion strength of the solder resist layer increases, and the solder resist layer becomes less likely to separate. Also, since the separation surface of the connection terminal is in contact with the solder resist layer, the reliability of connection between the connection terminal and the wiring increases.

Also, in the present invention, the second solder resist layer has an opening for exposing at least an upper end of the connection terminal, and a plurality of the connection terminals are disposed in the same opening, the first solder resist layer fills the spaces between the connection terminals, and the openings having an NSMD shape are formed only in the second solder resist layer.

Also, in another mode of the present invention, the wiring substrate is characterized in that the connection terminal is formed in a region which includes a large width portion of the wiring where the wiring has an increased wiring width, or a small width portion of the wiring where the wiring has a decreased wiring width.

According to the present invention, the area of contact between the connection terminal and the wiring increases. Therefore, the reliability of connection between the connection terminal and the wiring increases further.

Also, in another mode of the present invention, the wiring substrate is characterized in that the connection terminal is in contact with the opposite side surfaces of the wiring.

According to the present invention, the reliability of connection between the connection terminal and the wiring increases further.

### EFFECTS OF THE INVENTION

As described above, the present invention can provide a wiring substrate which allows connection terminals to be disposed at high density, can increase the degree of freedom of wiring layout, and can enhance the reliability of connection of the connection terminals.

### BRIEF DESCRIPTION OF THE DRAWINGS

[FIG. 1] Plan view of a wiring substrate according to an embodiment (front surface side).
[FIG. 2] Partial sectional view of the wiring substrate according to the embodiment.
[FIG. 3] Structural views of connection terminals and wirings on the front surface side of the wiring substrate according to the embodiment.
[FIG. 4] Enlarged views of a connection terminal and a wiring on the front surface side of the wiring substrate according to the embodiment.
[FIG. 5] Views showing a step of a process of manufacturing the wiring substrate according to the embodiment (core substrate step).
[FIG. 6] Views showing a step of the process of manufacturing the wiring substrate according to the embodiment (buildup step).
[FIG. 7] Views showing a step of the process of manufacturing the wiring substrate according to the embodiment (connection terminal forming step).
[FIG. 8] View showing a step of the process of manufacturing the wiring substrate according to the embodiment (connection terminal forming step).
[FIG. 9] Views showing a step of the process of manufacturing the wiring substrate according to the embodiment (connection terminal forming step).
[FIG. 10] View showing a step of the process of manufacturing the wiring substrate according to the embodiment (charging step).
[FIG. 11] Explanatory views showing a fourth charging method.
[FIG. 12] View showing a step of the process of manufacturing the wiring substrate according to the embodiment (solder resist layer step).
[FIG. 13] View showing a step of the process of manufacturing the wiring substrate according to the embodiment (plating step).
[FIG. 14] Structural views of wiring substrates according to a first modification of the embodiment.
[FIG. 15] Structural views of wiring substrates according to a second modification of the embodiment.

### MODES FOR CARRYING OUT THE INVENTION

An embodiment of the present invention will now be described with reference to the drawings. Notably, in the following description, the embodiment of the present invention will be described while referring, as an example, to a wiring substrate having buildup layers formed on a core substrate. However, the wiring substrate may be any wiring substrate so long as it has a plurality of connection terminals formed thereon, and may be a wiring substrate which includes no core substrate.

### (Embodiment)

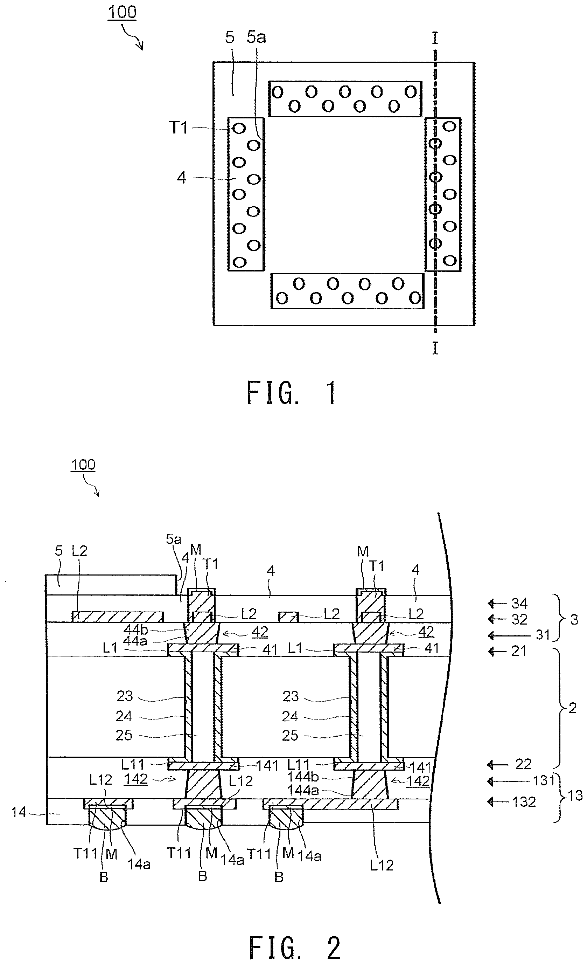

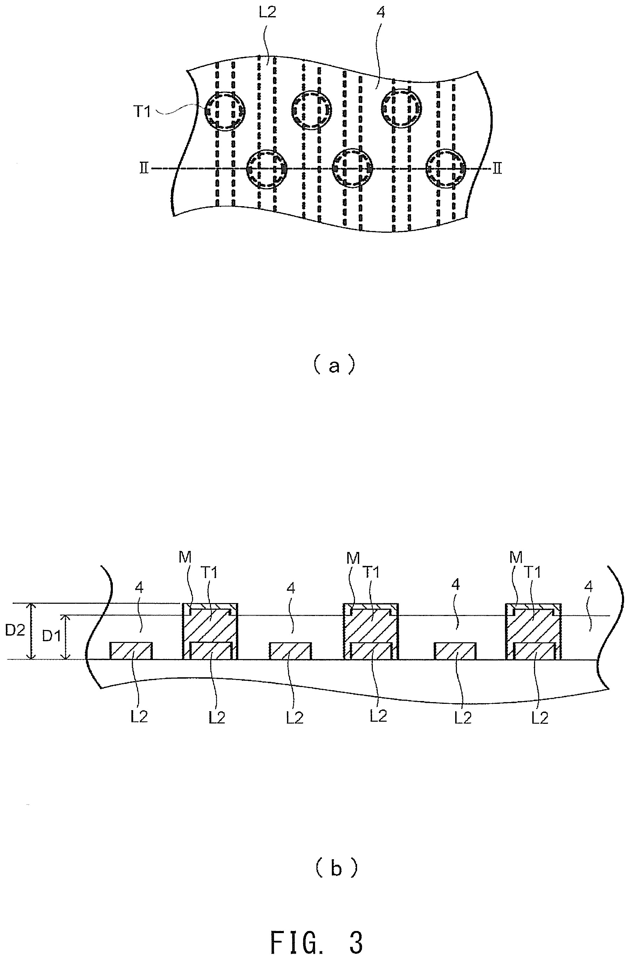

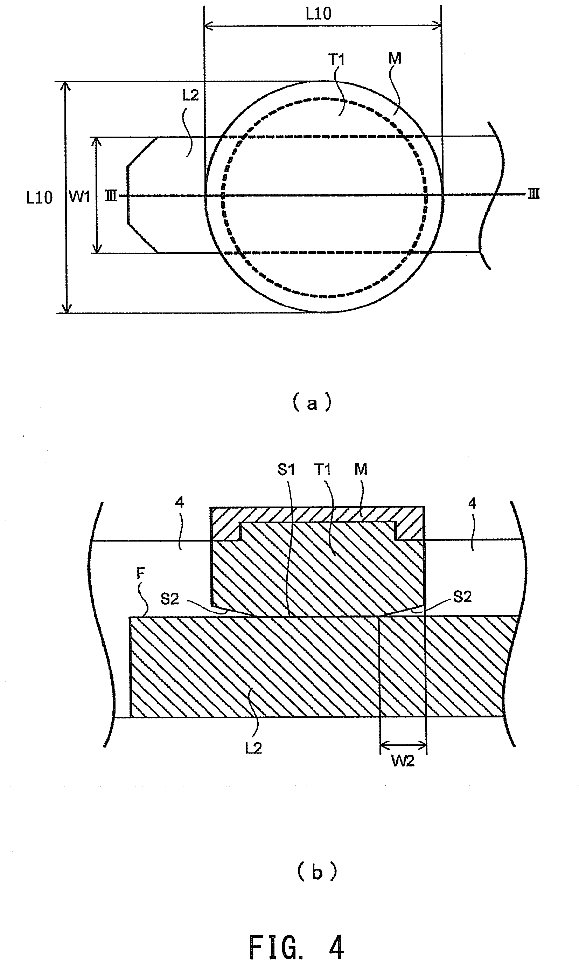

FIG. 1 is a plan view (front surface side) of a wiring substrate 100 according to the embodiment. FIG. 2 is a partial sectional view of the wiring substrate 100 taken along line I-I of FIG. 1. FIG. 3 is a pair of structural views of connection terminals T1 and wirings L2 formed on the front surface side of the wiring substrate 100. FIG. 3(a) is a plan view of the connection terminals T1 and the wirings L2, and FIG. 3(b) is a sectional view taken along line II-II of FIG. 3(a). FIG. 4 is a pair of enlarged views of a connection terminal T1 and a wiring L2. FIG. 4(a) is a plan view of the connection terminal T1 and the wiring L2, and FIG. 4(b) is a sectional view taken along line III-III of FIG. 4(a). Notably, in the following description, the side to which a semiconductor chip (component) is connected will be referred to as a front surface side, and the side to which a motherboard, a socket, etc. (hereinafter referred to a motherboard or the like) are connected will be referred to as a back surface side.

### (Structure of the wiring substrate 100)

The wiring substrate 100 shown in FIGS. 1 through 4 has a core substrate 2; a buildup layer 3 (front surface side) which has a plurality of connection terminals T1 for connection with a semiconductor chip (not shown) and which is laminated on the front surface side of the core substrate 2; a solder resist layer 4 which is formed on the buildup layer 3 and which fills the spaces between the plurality of connection terminals T1; a solder resist layer 5 which is laminated on the solder resist layer 4 and which has openings 5a for exposing the connection terminals T1; a buildup layer 13 (back surface side) which has a plurality of connection terminals T11 for connection with a motherboard (not shown) and which is laminated on the back surface side of the core substrate 2; and a solder resist layer 14 which is laminated on the buildup layer 13 and which has openings 14a for exposing at least a portion of each connection terminal T11.

The core substrate 2 is a plate-shaped resin substrate formed of, for example, a heat-resisting resin plate (e.g., bismaleimide-triazine resin plate) or a fiber-reinforced resin plate (e.g., glass-reinforced epoxy). Core conductor layers 21 and 22 which constitute metallic wirings L1 and L11 are formed on the front and back surfaces, respectively, of the core substrate 2. Also, through-holes 23 are formed in the core substrate 2 through use of a drill or the like, and through-hole conductors 24 for establishing electrical conduction between the core conductor layers 21 and 22 are formed on the walls of the through-holes 23. Further, the through-holes 23 are filled with a resin filler 25 such as epoxy resin or the like.

### (Structure on the front surface side)

A lid plating layer 41 electrically connected to the core conductor layer 21 is formed on the front surface side of the wiring substrate 100, and the lid plating layer 41 and a conductor layer 32 constituting metallic wirings L2 are electrically connected through filled vias 42. Each of the filled vias 42 has a via hole 44a and a via conductor 44b which is charged into the via hole 44a by means of plating.

The connection terminals T1 formed on the conductor layer 32 of the wiring substrate 100 are connection terminals for the semiconductor chip. The semiconductor chip is electrically connected to the connection terminals T1, whereby the semiconductor chip is mounted on the wiring substrate 100. In this embodiment, the connection terminals T1 are disposed at substantially equal intervals along the perimeter of a region in which the semiconductor chip is mounted (component mounting region).

Each connection terminal T1 has the shape of a column having a circular shape as viewed from above, and is formed directly on the corresponding wiring L2 in such a manner that an upper portion of the connection terminal T1 projects from the surface of the solder resist layer 4. Therefore, it is unnecessary to provide lands for the connection terminals T1. Also, the width W1 of each wiring L2 at a location where the corresponding connection terminal T1 is formed is smaller than the length L10 of the connection terminal T1 in the width direction. Therefore, the connection terminals T1 can be disposed at high density. Also, the degree of freedom of the layout of the wirings L2 increases.

Further, each connection terminal T1 is in contact with opposite side surfaces of the corresponding wiring L2. Therefore, the reliability of connection between the connection terminal T1 and the wiring L2 increases. Notably, the reliability of connection between the connection terminal T1 and the wiring L2 increases so long as the connection terminal T1 is in contact with at least one of the opposite side surfaces of the wiring L2. Notably, in this embodiment, the connection terminals T1 and the wirings L2 are formed of the same material (copper (Cu)). Since the material of the connection terminals T1 and the material of the wirings L2 are the same, the reliability of connection between the connection terminals T1 and the wirings L2 increases further.

Further, as shown in FIG. 4, in this embodiment, the lower surface of each connection terminal T1 which faces the upper surface F of the corresponding wiring L2 has a contact surface S1 which is in contact with the upper surface F of the wiring L2 and a separation surface S2 which is not in contact with the upper surface F of the wiring L2. Since the solder resist layer 4 enters the space between the separation surface S2 of the connection terminal T1 and the upper surface F of the wiring L2, the adhesion strength of the solder resist layer 4 increases. As a result, the solder resist layer 4 becomes less likely to separate. Also, since the separation surface S2 of the connection terminal T1 is in contact with the solder resist layer 4, the reliability of connection between the connection terminals T1 and the wirings L2 through the solder resist layer 4 increases.

Also, the surface of each connection terminal T1 is roughened in order to improve the adhesion to the solder resist layer 4. The surface of each connection terminal T1 can be roughened by treating the surface with etchant such as MECetchBOND (product of Mec. Co., Ltd.).

Further, a metal plating layer M is formed on a surface of each connection terminal T1 exposed from the solder resist layer 4. When a semiconductor chip is mounted on the wiring substrate 100, solder provided on the connection terminals of the semiconductor chip through coating is caused to reflow, whereby the connection terminals of the semiconductor chip are electrically connected to the connection terminals T1. Notably, the metal plating layer M is constituted by a single layer of, for example, Ni, Sn, Ag, Pd, or Au or a plurality of layers (for example, an Ni layer/an Au layer or an Ni layer/a Pd layer/an Au layer).

Also, instead of forming the metal plating layer M, OSP (Organic Solderability Preservative) treatment for rust prevention may be performed. Also, the exposed surface of each connection terminal T1 may be coated with solder. Alternatively, the metal plating layer M covering the exposed surface of each connection terminal T1 may be coated with solder.

The solder resist layer 4 fills the spaces between the connection terminals T1 formed on the surface layer of the buildup layer 3 so that the solder resist layer 4 is in close contact with the side surface of each connection terminal T1. Also, in order to expose the upper end of each connection terminal T1 (a portion of each connection terminal T1), the thickness D1 of the solder resist layer 4 is rendered smaller than the thickness (height) D2 of each connection terminal T1. Notably, the method of charging (forming) the solder resist layer 4 will be described later.

The solder resist layer 5 covers the front surface sides of the wirings L2 connected to the connection terminals T1, and has openings 5a for exposing the connection terminals T1 disposed at substantially equal intervals along the perimeter of the region in which the semiconductor chip is mounted. The openings 5a of the solder resist layer 5 have an NSMD (Non Solder Mask Defined) shape so that a plurality of connection terminals T1 are disposed in the same opening.

### (The structure on the back surface side)

A lid plating layer 141 electrically connected to the core conductor layer 22 is formed on the back surface side of the wiring substrate 100, and the lid plating layer 141 is connected to a conductor layer 132 through filled vias 142. Each of the filled vias 142 has a via hole 144a and a via conductor 144b charged in the via hole 144a by means of plating. Also, the conductor layer 132 has the connection terminals T11 for a motherboard (not shown).

The connection terminals T11 are used as back surface lands (PGA pads, BGA pads) for connecting the wiring substrate 100 to the motherboard or the like. The connection terminals T11 are formed in a peripheral region of the wiring substrate 100, which region is defined by excluding an approximately central portion of the wiring substrate 100, and the connection terminals T11 are arranged in a rectangular pattern around the approximately central portion. Also, at least a portion of the surface of each connection terminal T11 is covered with a metal plating layer M.

The solder resist layer 14 is formed by layering, on the surface of the buildup layer 13, a filmlike photosensitive insulating resin which functions as solder resist. The solder resist layer 14 has openings 14a formed for partially exposing the surfaces of the connection terminals T11. Therefore, a portion of the surface of each connection terminal T11 is exposed from the solder resist layer 14 through the corresponding opening 14a. Namely, the openings 14a of the solder resist layer 14 have an SMD (Solder Mask Defined) shape so that each opening 14a exposes a portion of the surface of the corresponding connection terminal T11. Notably, unlike the openings 5a of the solder resist layer 5, the openings 14a of the solder resist layer 14 are formed such that one opening 14a is provided for one connection terminal T11.

Solder balls B formed of solder which contain substantially no Pb, such as Sn-Ag, Sn-Cu, Sn-Ag-Cu, or Sn-Sb, are formed within the openings 14a in such a manner that the solder balls B are electrically connected to the connection terminals T11 through the metal plating layer M. Notably, when the wiring substrate 100 is mounted on the motherboard or the like, the solder balls B of the wiring substrate 100 are caused to reflow, whereby the connection terminals T11 are electrically connected to the connection terminals of the motherboard or the like.

### (Method of manufacturing the wiring substrate)

FIGS. 1 and 5 through 13 are views showing the steps of a method of manufacturing the wiring substrate 100 according to the embodiment. The method of manufacturing the wiring substrate 100 will now be described with reference to FIGS. 1 and 5 through 13.

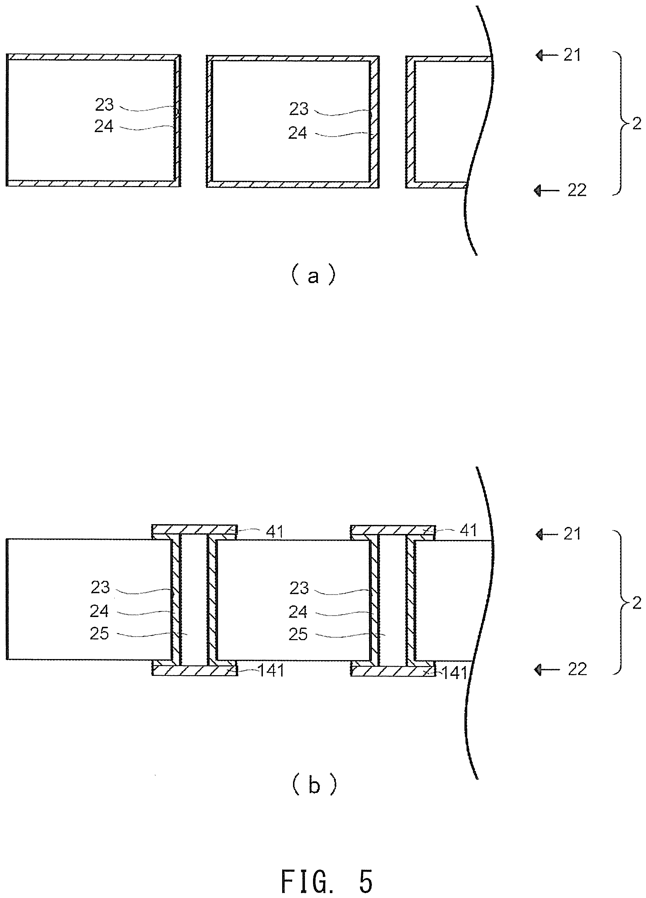

### (Core substrate step: FIG. 5)

A copper-clad laminate composed of a plate-shaped resin substrate and copper foils bonded to the front and back surfaces of the substrate is prepared. Also, through-holes which are to become the through-holes 23 are formed in advance in the copper-clad laminate at predetermined positions by performing drilling operation through use of a drill. Subsequently, electroless copper plating and electro copper plating are performed in accordance with conventionally known methods, whereby the through-hole conductors 24 are formed on the walls of the through-holes 23, and copper plating layers are formed on opposite surfaces of the copper-clad laminate (see FIG. 5(a)).

Subsequently, the spaces within the through-hole conductors 24 are filled with the resin filler 25 such as epoxy resin. Further, electro copper plating is performed in accordance with a conventionally known method, whereby the lid plating layer 41 is formed. Next, the copper plating layers (including the lid plating layer 41) formed on the copper foils on the opposite surfaces of the copper-clad laminate are etched into predetermined shapes so as to form the core conductor layers 21 and 22, which constitute the metal wirings L1 and L11, on the front and back surfaces of the copper-clad substrate, to thereby obtain the core substrate 2 (see FIG. 5(b)). Notably, it is preferred to perform desmearing after the step of forming the through-holes 23 so as to remove smears from the processed portions.

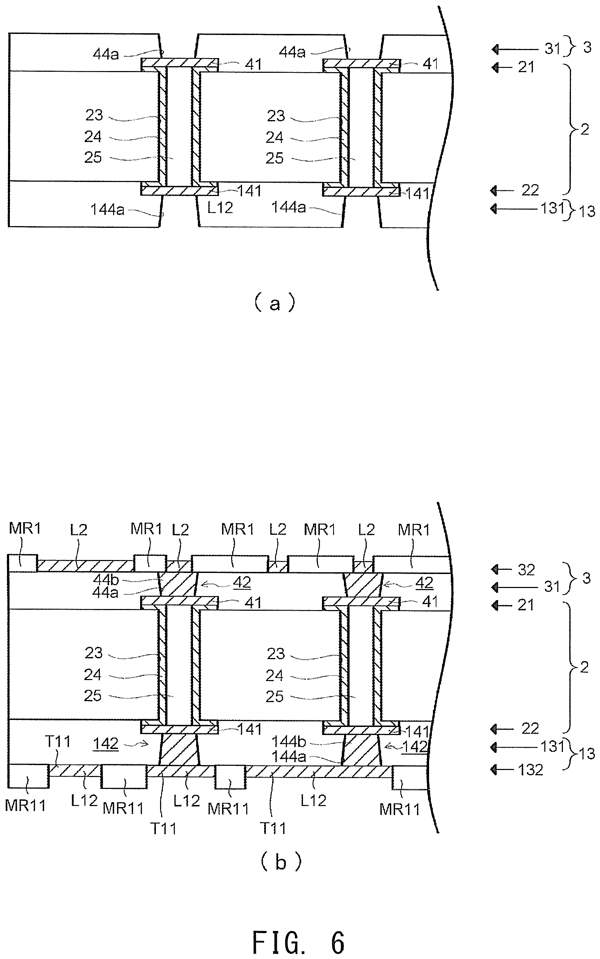

### (Buildup step: FIG. 6)

Filmlike insulating resin members which contain epoxy as a main component and which are to become the resin insulating layers 31 and 131 are disposed such that they overlie the front and back surfaces, respectively, of the core substrate 2. Pressure and heat are applied to the resultant laminate through use of a vacuum hot press so as to press-bond the filmlike insulating resin members while thermally curing the members. Next, laser irradiation is performed through use of a conventionally known laser machining apparatus so as to form the via holes 44a and 144a in the resin insulating layers 31 and 131, respectively (see FIG. 6(a)).

Subsequently, the surfaces of the resin insulating layers 31 and 131 are roughened, and electroless plating is performed so as to form electroless copper plating layers on the resin insulating layers 31 and 131 including the walls of the via holes 44a and 144a. Next, photo resist films are laminated on the electroless copper plating layers formed on the resin insulating layers 31 and 131, and exposure to light and development are performed, whereby plating resist layers MR1 and MR11 having desired shapes are formed. After that, while these plating resist layers MR1 and MR11 are used as masks, copper plating is performed by means of electro plating, whereby desired copper plating patterns (the metal wirings L2 and L12, and the connection terminals T11) are formed (see FIG. 6(b)).

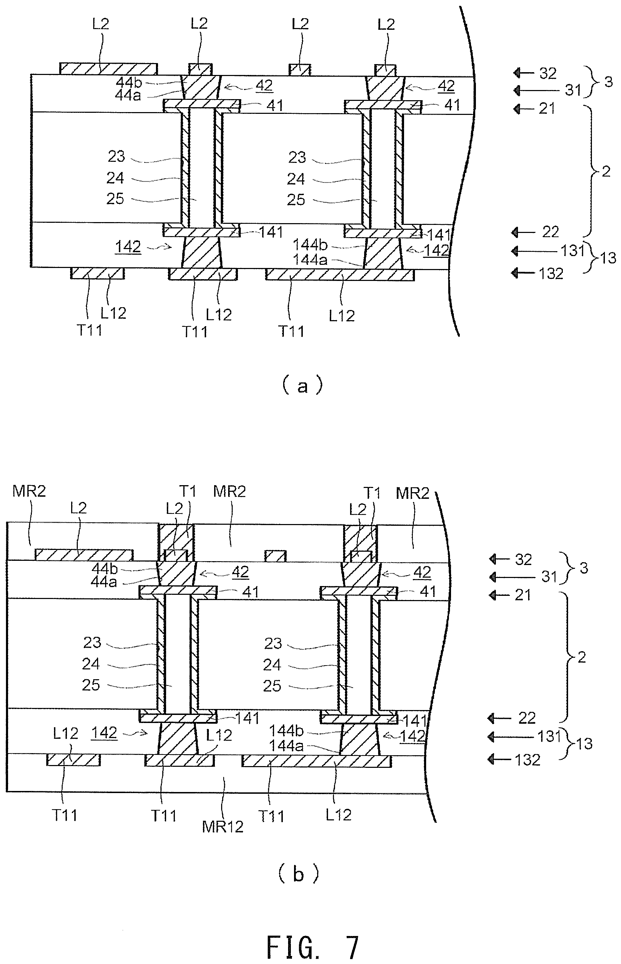

### (Connection terminal forming step: FIGS. 7 through 9)

Next, after the plating resist layers MR1 and MR11 are peeled off (see FIG. 7(a)), photo resist films are laminated, and exposure to light and development are performed, whereby plating resist layers MR2 and MR12 having desired shapes are formed. After that, while these plating resist layers MR2 and MR12 are used as masks, copper plating is performed by means of electro plating, whereby desired copper plating patterns (the connection terminals T1) are formed (see FIG. 7(b)).

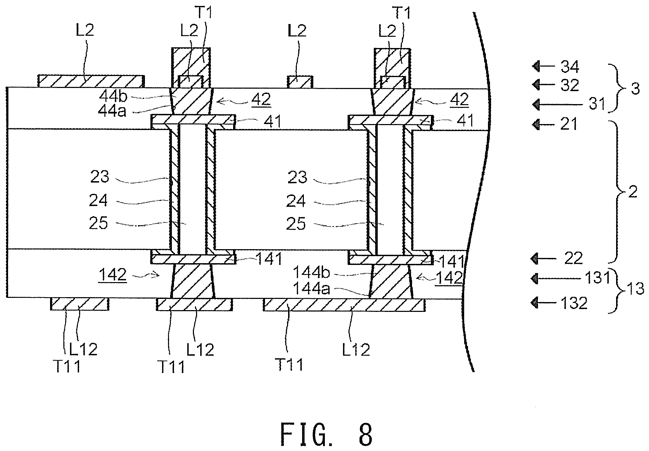

Next, after the plating resist layers MR2 and MR12 are peeled off, the electroless copper plating layers, excluding those under the copper plating layers, are removed, whereby the conductor layer 34 having the connection terminals T1 are obtained on the conductor layer 32 (see FIG. 8).

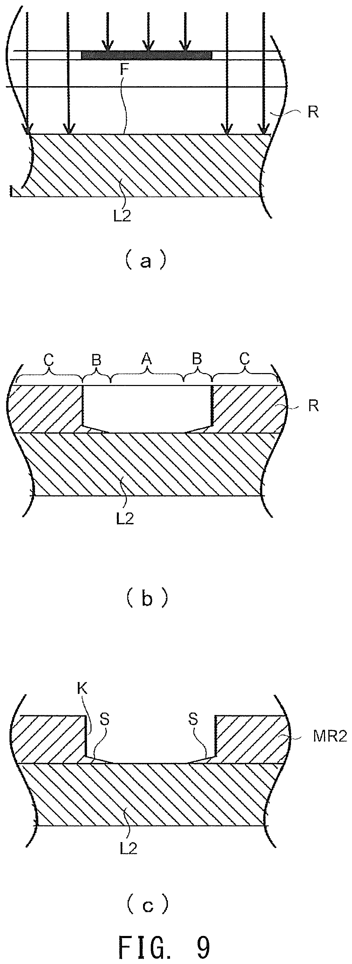

Next, the exposure and development of a photo resist film at the time of formation of the connection terminals T1 will be described with reference to FIG. 9. After a photo-curing photo resist film R is laminated, the laminated photo resist film R is exposed to light through a mask (see FIG. 9(a)). At the time of this exposure, the light exposure (exposure value) is made greater than that in the ordinary case. As a result of the light exposure being increased, the amount of light reflected backward by the upper surface F of each wiring L2 increases. As a result, in the photo resist film R, there are formed a region A in which the photo resist film R is not exposed to light and has not been cured, a region B in which a portion (lower portion) of the photo resist film R is exposed to the light reflected backward and in which a cured portion and an uncured portion are present, and a region C in which the photo resist film R has been cured as a result of exposure to light (see FIG. 9(b)).

Next, uncured portions of the photo resist film R are removed by performing a development process, whereby the resist layer MR2 for forming the connection terminals T1 is formed. Each of openings K of the resist layer MR2 in which the connection terminals T1 are formed has a bottom whose peripheral edge S is raised (see FIG. 9(c)). Therefore, when the connection terminals T1 are formed by means of electro plating, the lower surface of each connection terminal T1 which faces the upper surface F of the wiring L2 has the contact surface S1 and the separation surface S2.

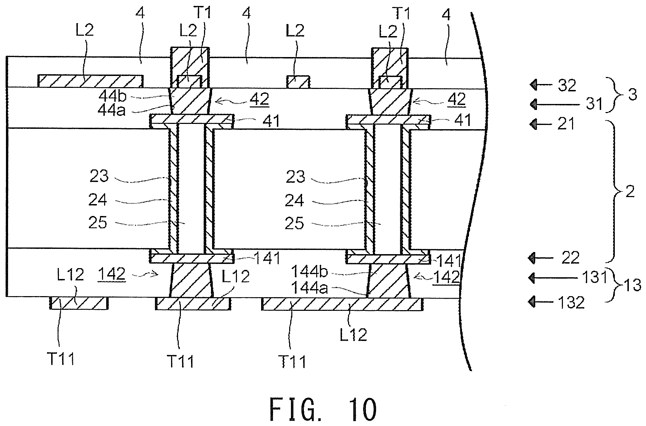

### (Charging step: FIG. 10)

Next, the solder resist layer 4 is formed in such a manner that the solder resist layer 4 fills the spaces between the plurality of connection terminals T1, which constitute the surface layer of the buildup layer 3, to a position lower than upper faces of the connection terminals T1 (see FIG. 10). Notably, in order to allow the solder resist layer 4 to fill the spaces between the connection terminals T1, it is preferred to roughen the surfaces (in particular, side surfaces) of the connection terminals T1. The surface of each connection terminal T1 can be roughened by treating the surface with etchant such as MECetchBOND (product of Mec. Co., Ltd.). Also, in stead of roughening the surface of each connection terminal T1, the following process may be performed so as to improve the adhesion to the solder resist layer 4. Namely, the surface of each connection terminal T1 is coated with a metallic element selected from Sn (tin), Ti (titanium), Cr (chromium), and Ni (nickel) so as to form a metallic layer on the surface, and a coupling agent is applied to the metallic layer, whereby the adhesion to the solder resist layer 4 is improved.

Any of various methods can be employed so as to charge the solder resist layer 4 into the spaces between the connection terminals T1. Below, there will be described methods of charging the solder resist layer 4 into the spaces between the connection terminals T1. Notably, in the following first through fourth charging methods, various techniques such as printing, lamination, roll coating, and spin coating may be used as a method of applying, by means of coating, an insulative resin which is to become the solder resist layer 4.

### (First charging method)

In this first charging method, the surface of the buildup layer 3 having the connection terminals T1 formed in the surface layer thereof is coated with a thermosetting insulative resin, whereby a thin coating layer of the insulative resin is formed. After the thin coating layer is thermally cured, the cured thin coating layer is polished until the thickness of the coating layer becomes smaller than the height of the connection terminals T1, whereby the solder resist layer 4 is formed to fill the spaces between the connection terminals T1.

### (Second charging method)

In this second charging method, the surface of the buildup layer 3 having the connection terminals T1 formed in the surface layer thereof is coated with a thermosetting insulative resin, whereby a thin coating layer of the insulative resin is formed. Subsequently, an excessive portion of the insulative resin which covers the upper surfaces of the connection terminals T1 is removed through use of a solvent which melts the insulative resin, and the thin coating layer of the insulative resin is thermally cured, whereby the solder resist layer 4 is formed to fill the spaces between the connection terminals T1.

### (Third charging method)

In this third charging method, the surface of the buildup layer 3 having the connection terminals T1 formed in the surface layer thereof is coated with a thermosetting insulative resin, whereby a thick coating layer of the insulative resin is formed. After the thin coating layer is thermally cured, the thin coating layer is masked in a region outside regions which are formed around the semiconductor device mounting region and which are to become the openings 5a of the solder resist layer. In this state, dry etching is performed by RIE (Reactive Ion Etching) or the like until the thickness of the coating layer becomes smaller than the height of the connection terminals T1, whereby the solder resist layer 4 is formed to fill the spaces between the connection terminals T1. Notably, in the case where this third charging method is used to form the solder resist layer 4 in such a manner that it fills the spaces between the connection terminals T1, the solder resist layer 4 and the solder resist layer 5 are formed integrally.

### (Fourth charging method)

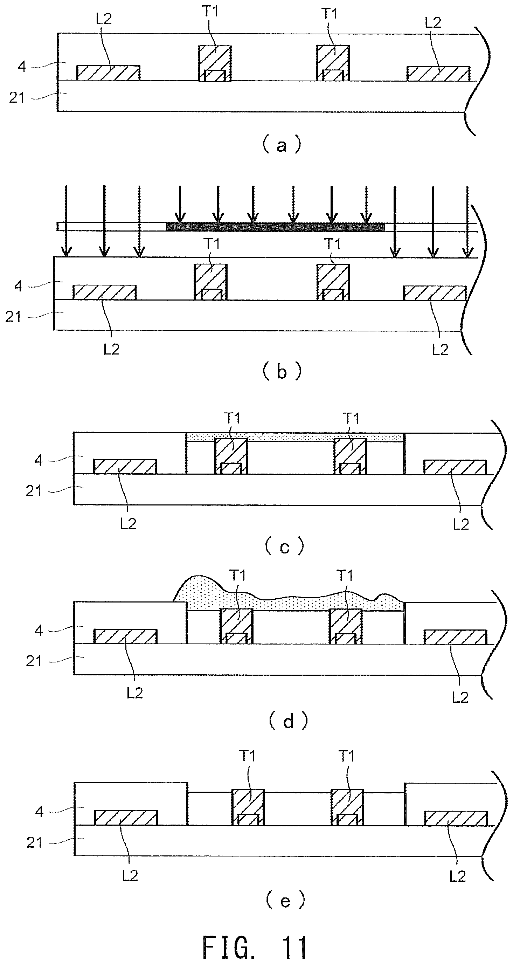

FIG. 11 is a set of explanatory views showing a fourth charging method. The fourth charging method will now be described with reference to FIG. 11. In the fourth charging method, the surface of the buildup layer 3 having the connection terminals T1 formed in the surface layer thereof is coated with a photo-curing insulative resin, whereby a thick coating layer of the insulative resin is formed (see FIG. 11(a)). Subsequently, the coating layer of the insulative resin is masked in regions which are to become the openings 5a of the solder resist layer, and the coating layer of the insulative resin is exposed to light, followed by development. As a result, a portion of the coating layer of the insulative resin which corresponds to the region outside the openings 5a is optically cured (see FIG. 11(b)). Next, the wiring substrate 100 in the middle of manufacture is immersed into a sodium carbonate aqueous solution (concentration: 1 wt.%) for a short period of time (a period of time during which the surface of an unexposed portion of the insulative resin swells slightly (see FIG. 11(c)). After that, the wiring substrate 100 is rinsed with water so as to emulsify the swelled insulative resin (see FIG. 11(d)). Next, the swelled and emulsified insulative resin is removed from the wiring substrate 100 in the middle of manufacture (see FIG. 11(e)). Each of the above-described immersion and rinsing is performed one time or is repeated several times until the position of the upper end of the coating layer formed of the insulative resin having not been optically cured becomes lower than the upper end of each connection terminal T1. After that, the insulative resin is cured by means of heat or ultraviolet light. Notably, in the case where this fourth charging method is used to form the solder resist layer 4 in such a manner that it fills the spaces between the connection terminals T1, the solder resist layer 4 and the solder resist layer 5 are formed as a single layer.

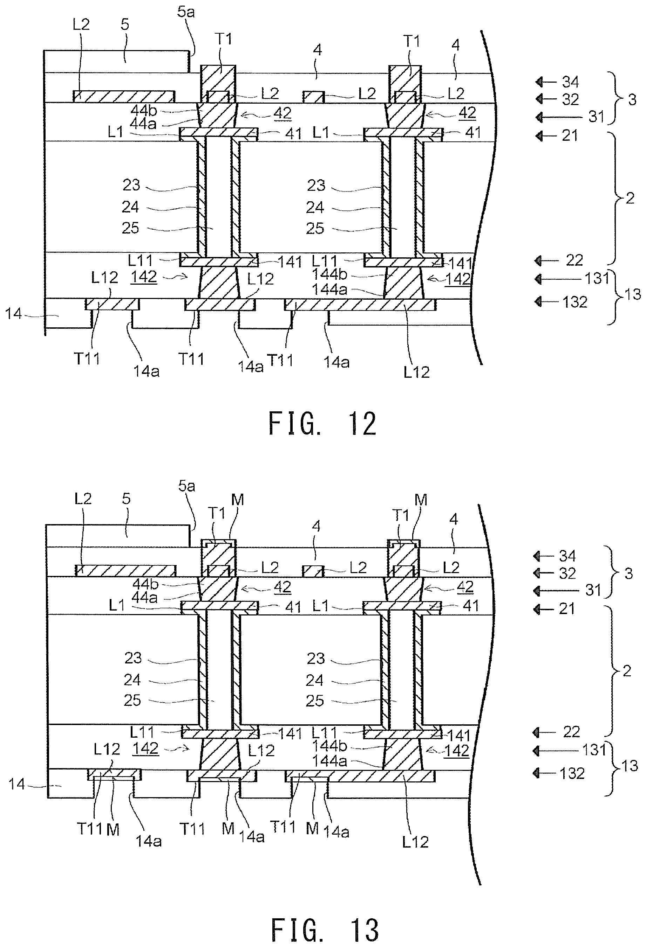

### (Solder resist layer step: FIG. 12)

A filmlike photosensitive insulating resin which functions as solder resist is laminated, by means of press operation, on each of the surface of the solder resist layer 4 and the surface of the buildup layer 13. The laminated filmlike insulative resin is exposed to light, followed by development, whereby the solder resist layer 5 and the solder resist layer 14 are obtained. The solder resist layer 5 has the openings 5a which have an NSMD shape and which expose the front and side surfaces of the connection terminals T1. The solder resist layer 14 has the openings 14a which have an SMD shape and which partially expose the surfaces of the connection terminals T11. Notably, in the case where the above-described third or fourth charging method is employed in the charging step, the solder resist layer 4 and the solder resist layer 5 are formed integrally. Therefore, it is unnecessary to laminate the solder resist layer 5 in this step.

### (Plating step: FIG. 13)

Next, impurities such as oxide film are removed from the surfaces of the connection terminals T1 by etching the exposed surfaces of the connection terminals T1 through use of sodium persulfate or the like. After that, by means of electroless reduction plating performed through use of a reducing agent, the metal plating layer M is formed on each of the exposed surfaces of the connection terminals T1 and T11. In the case where the metal plating layer M is formed on each of the exposed surfaces of the connection terminals T1 by means of electroless displacement plating, the metal of the exposed surface of each connection terminal T1 is displaced, whereby the metal plating layer M is formed.

### (Back end step: FIG. 1)

The solder balls B are disposed on the metal plating layers M formed on the connection terminals T11, and are caused to reflow, whereby the solder balls B are joined to the connection terminals T11.

As described above, in the wiring substrate 100 of the present embodiment, the connection terminals T1 are formed directly on the wirings L2. Therefore, it is unnecessary to provide lands for the connection terminals T1. Also, the width W1 of each wiring L2 at a position where the corresponding connection terminal T1 is formed is smaller than the length L10 of the connection terminal T1 in the width direction. Therefore, the connection terminals T1 can be disposed at high density. Also, the degree of freedom of the layout of the wirings L2 can be increased.

Further, each connection terminal T1 is in contact with the opposite side surfaces of the corresponding wiring L2. Therefore, the reliability of connection between the connection terminal T1 and the wiring L2 increases. Notably, the reliability of connection between the connection terminal T1 and the wiring L2 increases so long as the connection terminal T1 is in contact with at least one of the opposite side surfaces of the wiring L2. Also, the connection terminals T1 and the wirings L2 are formed of the same material (copper (Cu)). Since the material of the connection terminals T1 and the material of the wirings L2 are the same, the reliability of connection between the connection terminals T1 and the wirings L2 increases further.

Further, the lower surface of each connection terminal T1 which faces the upper surface F of the corresponding wiring L2 has a contact surface S1 which is in contact with the upper surface F of the wiring L2 and a separation surface S2 which is not in contact with the upper surface F of the wiring L2. The solder resist layer 4 is formed to fill the space between the separation surface S2 of the connection terminal T1 and the upper surface F of the wiring L2. Therefore, the adhesion strength of the solder resist layer 4 increases, and the solder resist layer 4 becomes less likely to separate.

Other advantageous effects are as follows. Since the solder resist layer 4 fills the spaces between the connection terminals T1, it is possible to prevent generation of voids, between the connection terminals T1, in underfill, NCP (Non-Conductive Paste), or NCF (Non-Conductive Film) charged in the gap between the semiconductor chip and the wiring substrate, which voids would otherwise are generated when the semiconductor chip is connected to the wiring substrate. Therefore, it is possible to prevent formation of a short circuit between the connection terminals which is formed as a result of flow of solder into the voids at the time of reflow.

Also, the surfaces of the connection terminals T1 which are in contact with the solder resist layer 4 are roughened, and the solder resist layer 4 is formed to fill the spaces between the connection terminals T1. Therefore, the strength of bonding between the connection terminals T1 and the solder resist layer 4 increases. Also, since the material of the solder resist layer 4 is the same as that of the solder resist layer 5, the solder flowability of the solder resist layer 4 is approximately the same as that of the solder resist layer 5. Therefore, it is possible to prevent solder from remaining on the solder resist layer 4 and forming a short circuit between the connection terminals T1.

Also, the thickness D1 of the solder resist layer 4 filling the spaces between the connection terminals T1 is rendered smaller than the thickness (height) D2 of the connection terminals T1. Namely, the solder resist layer 4 is formed in such a manner that the connection terminals T1 slightly project from the upper surface of the solder resist layer 4. Therefore, even in the case where the center of each connection terminal of the semiconductor chip deviates from the center of the corresponding connection terminal T1, the connection terminal of the semiconductor chip comes into contact with an end portion of the connection terminal T1. Therefore, the reliability of connection between each connection terminal T1 and the corresponding connection terminal of the semiconductor chip increases.

### (First modification of the embodiment)

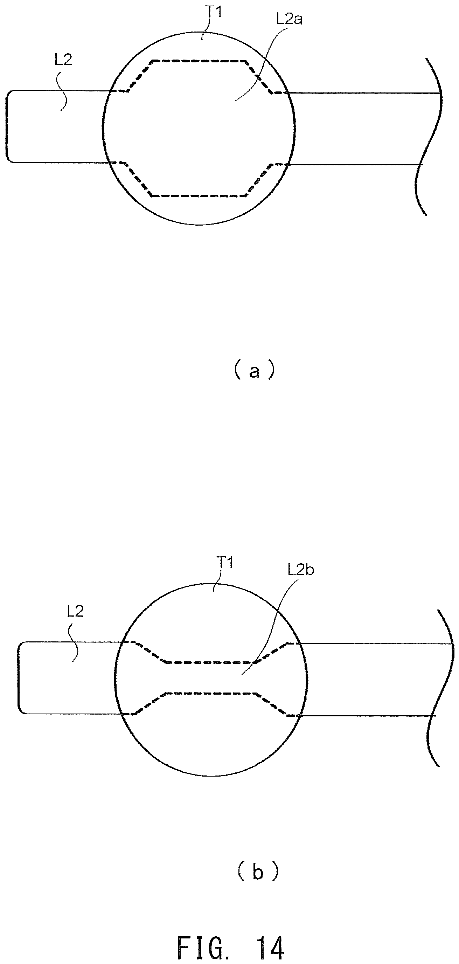

FIG. 14 is a pair of plan views of connection terminals T1 and wirings L2 of wiring substrates according to a first modification of the embodiment. In the wiring substrate 100 according to the embodiment having been described with reference to FIGS. 1 through 13, each wiring L2 has a straight shape. However, each wiring L2 may be formed to have a large width portion L2a having an increased wiring width (see FIG. 14(a)) or a small width portion L2b having a decreased wiring width (see FIG. 14(b)). In this case, the connection terminal T1 is formed in a region which includes the large width portion L2a or the small width portion 12b. When the connection terminal T1 is formed in such a region, the area of contact between the connection terminal T1 and the wiring L2 increases. As a result, the reliability of contact between the connection terminal T1 and the wiring L2 increases further.

### (Second modification of the embodiment)

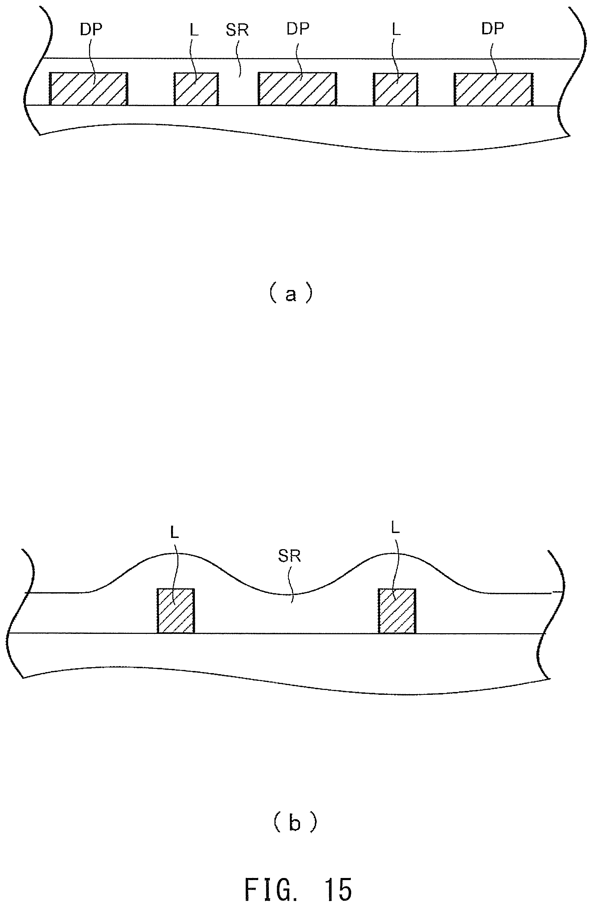

FIG. 15(a) is a partial sectional view of a wiring substrate according to a second modification of the embodiment. FIG. 15(b) is a partial sectional view of a wiring substrate according to a comparative example. In the case where the disposing density of the wirings L of the wiring substrate varies with position as shown in FIG. 15(a), dummy planes DP may be provided simultaneously when the wirings L are formed by means of electro plating. In the case where the dummy planes DP are provided in such a manner that the wirings L and the dummy planes DP are arranged evenly, it is possible to avoid a problem of current concentration at the time of electro plating, which current concentration would otherwise occur due to variation of the disposing density of the wirings L. As a result, a variation in the thickness of the wirings L is restrained. Also, it is possible to restrain generation of irregularities on the surface of the solder resist layer formed on the wirings L by means of coating. Meanwhile, in the case where the disposing density of the wirings L of the wiring substrate varies with position as shown in FIG. 15(b) (comparative example), irregularities are formed on the surface of the solder resist layer formed on the wirings L by means of coating.

In the above, the present invention has been described in detail on the basis of its concrete examples. However, the present invention is not limited to the above-described examples, and may be modified or changed without departing from the scope of the present invention. For example, in the above-described concrete examples, the wiring substrate 100 is a BGA substrate which is connected to a motherboard or the like through solder balls B. However, the wiring substrate 100 may be a PGA (Pin Grid Array) substrate or an LGA (Land Grid Array) in which pins or lands are provided in place of the solder balls B.

Further, in the present embodiment, when the first or second charging method is employed, the solder resist layer 5 is formed after formation of the solder resist layer 4. However, the solder resist layer 4 may be formed to fill the spaces between the connection terminals T1 after formation of the solder resist layer 5.

### DESCRIPTION OF SYMBOLS

B ··· solder ball; F ···upper surface of metal wiring L2; L1, L11 ··· metal wiring; L2, L12 ··· metal wiring; L2a ··· large width portion; MR1, MR11 ··· plating resist; MR2, MR12 ··· plating resist; T1, T11 ··· connection terminal; W ··· wiring width; 100 ··· wiring substrate; 2 ··· core substrate; 3 ··· buildup layer; 4, 5 ··· solder resist layer; 5a ··· opening; 13 ··· buildup layer; 14 ··· solder resist layer; 14a ··· opening; 21, 22 ··· core conductor layer; 23 ··· through-hole; 24 ··· through-hole conductor; 31, 131 ··· resin insulating layer; 32, 132 ··· conductor layer; 42 ··· filled via; 44a, 144a ··· via hole; 44b ··· via conductor, 34 ··· conductor layer; 142 ··· filled via.

## Claims

1. A wiring substrate (100) comprising:
a laminate which includes one or more insulating layers (4,5,14,31,131) and one or more conductor layers (21,22,32,132) laminated together;
a wiring (L1,L2,L11,L12) formed on the laminate;
a columnar connection terminal (23,24) which is formed directly on the wiring and is in contact with at least one of opposite side surfaces of the wiring; and
a solder resist layer (4,5,14) which covers the wiring and which exposes at least a portion of the connection terminal (T1,T11),
wherein a width (W1) of the wiring (L2) at a position at which the connection terminal (T1) is formed is smaller than a length (L1) of the connection terminal (T1) in the width direction
a lower surface of the connection terminal (T1) which faces an upper surface (F) of the wiring (L2) has a contact surface (S1) which is in contact with the upper surface (F) of the wiring (L2) and a separation surface (S2) which is not in contact with the upper surface (F) of the wiring (L2), and a gap between the separation surface (S2) and the upper surface (F) of the wiring (L2) is filled with the first solder resist layer (4),
**characterized in that** the solder resist layer comprises a first solder resist layer (4) and a second solder resist layer (5), wherein
the second solder resist layer (5) has an opening (5a) for exposing at least an upper end of the connection terminal (T1),
a plurality of the connection terminals (T1) are disposed in the same opening (5a),
the first solder resist layer (4) fills the spaces between the connection terminals (T1), and
the openings (5a) formed in the second solder resist layer (5) have an NSMD shape.

2. A wiring substrate (100) according to claim 1,
wherein the connection terminal (T1) and the wiring (L2) are formed of the same material.

3. A wiring substrate (100) according to any one of claims 1 to 2, wherein the connection terminal (T1) is formed in a region which includes a large width portion (L2a) of the wiring (L2) where the wiring has an increased wiring width, or a small width portion (L2b) of the wiring (L2) where the wiring has a decreased wiring width.

4. A wiring substrate (100) according to any one of claims 1 to 3, wherein the connection terminal (T1) is in contact with the opposite side surfaces of the wiring (L2).

## Patentansprüche

1. Leitersubstrat (100), umfassend:
ein Laminat, das eine oder mehrere Isolierschichten (4, 5, 14, 31, 131) und eine oder mehrere Leiterschichten (21, 22, 32, 132) beinhaltet, die zusammen laminiert sind,
eine Verdrahtung (L1, L2, L11, L12), die auf dem Laminat ausgebildet ist,
ein säulenförmiger Verbindungsanschluss (23, 24), der direkt auf der Verdrahtung ausgebildet ist und mit mindestens einer von gegenüberliegenden Seitenflächen der Verdrahtung in Kontakt steht, und
eine Lötstopplackschicht (4, 5, 14), welche die Verdrahtung abdeckt und welche zumindest einen Teil des Verbindungsanschlusses (T1, T11) freilegt,
wobei eine Breite (W1) der Verdrahtung (L2) in einer Position, in der der Verbindungsanschluss (T1) ausgebildet ist, kleiner ist als eine Länge (L1) des Verbindungsanschlusses (T1) in der Breitenrichtung
eine untere Fläche des Verbindungsanschlusses (T1), die einer oberen Fläche (F) der Verdrahtung (L2) zugewandt ist, eine Kontaktfläche (S1), die mit der oberen Fläche (F) der Verdrahtung (L2) in Kontakt steht, und eine Trennfläche (S2) aufweist, die mit der oberen Fläche (F) der Verdrahtung (L2) nicht in Kontakt steht, und ein Spalt zwischen der Trennfläche (S2) und der oberen Fläche (F) der Verdrahtung (L2) mit der ersten Lötstopplackschicht (4) gefüllt ist,
**dadurch gekennzeichnet, dass** die Lötstopplackschicht eine erste Lötstopplackschicht (4) und eine zweite Lötstopplackschicht (5) umfasst, wobei
die zweite Lötstopplackschicht (5) eine Öffnung (5a) zum Freilegen von mindestens einem oberen Ende des Verbindungsanschlusses (T1) aufweist,
mehrere der Verbindungsanschlüsse (T1) in derselben Öffnung (5a) angeordnet sind,
die erste Lötstopplackschicht (4) die Räume zwischen den Verbindungsanschlüssen (T1) ausfüllt, und
die in der zweiten Lötstopplackschicht (5) gebildeten Öffnungen (5a) eine NSMD-Form aufweisen.

2. Leitersubstrat (100) nach Anspruch 1, wobei der Verbindungsanschluss (T1) und die Verdrahtung (L2) aus dem gleichen Material gebildet sind.

3. Leitersubstrat (100) nach einem der Ansprüche 1 bis 2, wobei der Verbindungsanschluss (T1) in einem Bereich ausgebildet ist, der einen Teil (L2a) mit großer Breite der Verdrahtung (L2), in dem die Verdrahtung eine vergrößerte Verdrahtungsbreite aufweist, oder einen Teil (L2b) mit kleiner Breite der Verdrahtung (L2) beinhaltet, in dem die Verdrahtung eine verringerte Verdrahtungsbreite aufweist.

4. Leitersubstrat (100) nach einem der Ansprüche 1 bis 3, wobei der Verbindungsanschluss (T1) mit den gegenüberliegenden Seitenflächen der Verdrahtung (L2) in Kontakt steht.

## Revendications

1. Substrat de câblage (100) comprenant :
un stratifié qui comporte une ou plusieurs couches isolantes (4, 5, 14, 31, 131) et une ou plusieurs couches conductrices (21, 22, 32, 132) stratifiées ensemble ;
un câblage (L1, L2, L11, L12) formé sur le stratifié ;
une borne de connexion (23, 24) en forme de colonne qui est formée directement sur le câblage et est en contact avec au moins une des surfaces latérales opposées du câblage ; et
une couche de soudure de résistance (4, 5, 14) qui recouvre le câblage et qui expose au moins une partie de la borne de connexion (T1, T11),
dans lequel une largeur (W1) du câblage (L2) à une position à laquelle la borne de connexion (T1) est formée est plus petite qu'une longueur (L1) de la borne de connexion (T1) dans la direction de la largeur,
une surface inférieure de la borne de connexion (T1) qui fait face à une surface supérieure (F) du câblage (L2) a une surface de contact (S1) qui est en contact avec la surface supérieure (F) du câblage (L2) et une surface de séparation (S2) qui n'est pas en contact avec la surface supérieure (F) du câblage (L2), et un espacement entre la surface de séparation (S2) et la surface supérieure (F) du câblage (L2) est rempli avec la première couche de soudure de résistance (4),
**caractérisé en ce que** la couche de soudure de résistance comprend une première couche de soudure de résistance (4) et une deuxième couche de soudure de résistance (5), dans laquelle
la deuxième couche de soudure de résistance (5) a une ouverture (5a) pour exposer au moins une extrémité supérieure de la borne de connexion (T1),
une pluralité de bornes de connexion (T1) sont disposées dans la même ouverture (5a),
la première couche de soudure de résistance (4) remplit les espaces entre les bornes de connexion (T1), et
les ouvertures (5a) formées dans la deuxième couche de soudure de résistance (5) ont une forme NSMD.

2. Substrat de câblage (100) selon la revendication 1, dans lequel la borne de connexion (T1) et le câblage (L2) sont formés du même matériau.

3. Substrat de câblage (100) selon l'une quelconque des revendications 1 et 2, dans lequel la borne de connexion (T1) est formée dans une région qui comporte une partie de grande largeur (L2a) du câblage (L2) où le câblage a une largeur de câblage accrue, ou une partie de petite largeur (L2b) du câblage (L2) où le câblage a une largeur de câblage réduite.

4. Substrat de câblage (100) selon l'une quelconque des revendications 1 à 3, dans lequel la borne de connexion (T1) est en contact avec les surfaces latérales opposées du câblage (L2).
